Europäisches Patentamt

European Patent Office

Office européen des brevets

(11) Publication number: **0 361 984**
**A1**

## (12) EUROPEAN PATENT APPLICATION

(21) Application number: **89310069.3**

(22) Date of filing: **02.10.89**

(51) Int. Cl.5: **H01L 21/00 , G02B 6/30**

(30) Priority: **30.09.88 GB 8823030**

(43) Date of publication of application:
**04.04.90 Bulletin 90/14**

(84) Designated Contracting States:
**AT BE CH DE ES FR GB GR IT LI LU NL SE**

(71) Applicant: **BRITISH TELECOMMUNICATIONS
public limited company
81 Newgate Street
London EC1A 7AJ(GB)**

(72) Inventor: **Knox, Andrew Stuart
Forge Cottage 254 High Street Walton
Felixstowe Suffolk IP11 9DS(GB)**

(74) Representative: **Pratt, David Martin et al
Intellectual Property Unit British Telecom
151 Gower Street
London WC1E 6BA(GB)**

(54) **A holder.**

(57) A holder (1) for holding lithium niobate structures during transportation and processing comprising a frame (2) having fixed second grips (4,5) and resiliently mounted first grip (6). The distance between the first and second grips can be increased to allow a substrate to be placed therebetween by squeezing the first grip and the frame together. On releasing the first grip and the support, the first grip returns to its original position, and the substrate is securely held in place in a manner which minimises the area of the substrate which comes into contact with the holder.

Fig. 1.

EP 0 361 984 A1

## A HOLDER

This invention relates to a holder for holding an object, and particularly, but not exclusively, to a holder for holding a lithium niobate substrate during processing and transportation.

Substrates themselves or structures formed on their surfaces can be very fragile and therefore must be very delicately handled during processing, and carefully transported and stored. Often, it is also necessary to keep such substrates scrupulously clean during handling and processing, and so contact with other apparatus, or with a processor's hand should be minimised.

A known container for holding a substrate comprises a container of substantially circular cross-section having a base and a lid which is screw fitted thereto. The internal base has a concave surface such that when a substrate is placed in it, the substrate touches the base at its edges. The substrate is held in place by a resilient convex holder (spider) which fits into the container, and holds the substrate in place by forming a contact with it on its edges. When the lid of the container is screwed on the 'spider' presses the substrate against the base so holding it in place. The substrate may then be protected within the container. This type of known holder is adapted to hold one substrate within the container.

A disadvantage with this known type of holder is that the spider contacts a relatively large area of substrate to hold it in position. Also, it is designed for use with substantially circular substrates of a given size. Thus it cannot be used to hold a smaller substrate as it would be possible for the substrate to move around within the container. This would result in damage to the surface of the substrate caused by its surface coming into contact with the 'spider' or the lid.

It is an object of the present invention to provide a holder which overcomes these disadvantages.

According to the invention there is provided a holder for holding an object comprising a frame having first and second gripping means co-operable to hold the object, the first gripping means being resiliently flexible so as to be displaceable away from the second gripping means by squeezing it and a portion of the frame together thereby permitting the object to be placed between the first and second gripping means to be held by them on releasing the first gripping means.

Once the object is in place the first gripping means and the portion of the frame are released allowing the first gripping means to return towards its original position, thus the object is gripped between the first and second gripping means. The first and second gripping means grip the edges of the object and have minimum contact with the faces of the substrate.

The holder holds the object such that it does not come into contact with the container. The holder may thus be used in conjunction with containers of various sizes. If the container is very large, the holder will move around within it, but the substrate, being held firmly by the holder will not be harmed by the movement.

Preferably, the second gripping means comprises first and second spaced apart grooved portions of the frame, and the first gripping means comprises a third grooved portion having a connecting portion connected to the frame by a resilient support, a portion of the first gripping means extending between the two spaced apart grooved portions.

The resilient support allows resiliently flexible movement of the first gripping means relative to the frame, and hence the second gripping means. The resilient support may be on the same side of the first and second grooved portion as the third grooved portion, but preferably it is on the opposite side of the first and second grooved portions to the third grooved portion as this provides stability during the squeezing action.

The resilient support may be an elastic material fixed between the first gripping means and the frame, but preferably it is formed by a thin strip of the frame, for ease of manufacture. The thinness of the strip results in it being more resiliently flexible than the frame to a degree which can be predetermined as required. The grooved portions are useful for holding the substantially planar substrate.

Preferably, the first, second and third grooved portions each comprise a ledge portion and a planar sloped portion at an acute angle to the ledge portion, the ledge portions being substantially co-planar and located to support the object. Hence an object which has been placed between the grooved portions will be guided down by the slope of each sloped portion until a small portion of its under surface rests on the flat surface of each ledge portion. The object is then firmly held in place.

Most preferably, the plane in which the ledge portions lie is such that the object is spaced apart from the connecting portion when in a held position and hence does not come into contact with it. If the object has only one delicate surface this will not be necessary. However by providing the connecting portion with a sloping portion adjacent the resilient support and extending between the first and second grooved portions, tweezers can be easily put into position to grip the object when it is required to remove the object from the holder, by allowing one side of the tweezers to slip easily under the object. This is used with single or double sided substrates.

Advantageously, the frame portion is spaced apart from the first gripping means and located such that it limits the maximum displacement of the first gripping means. This avoids undue strain being placed on the gripping means due to excessive displacement.

An embodiment of invention will now be described by way of example only with reference to the accompanying drawings in which:

Figure 1 is a plan view of a holder according to the invention;

Figure 2 is a cross section of the holder of figure 1 viewed along line II-II of figure 1;

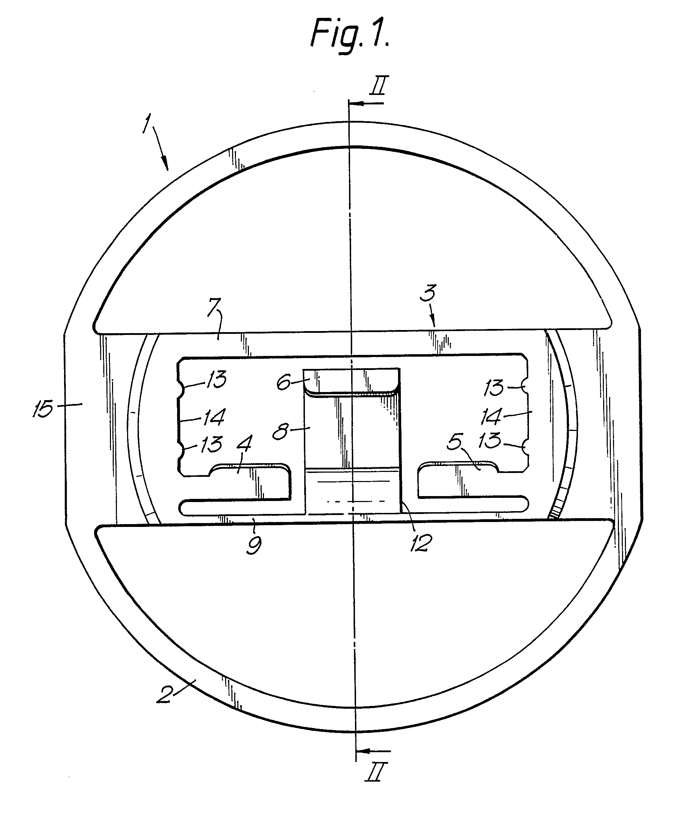

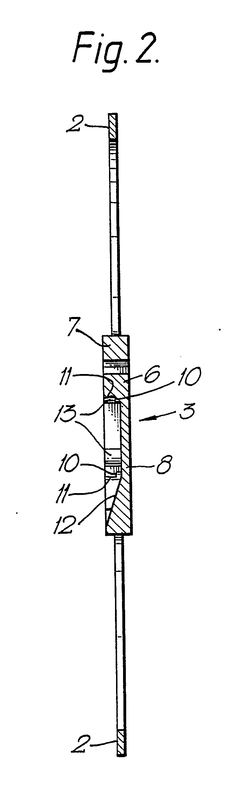

Referring to figures 1 and 2 a holder 1 comprises an outer frame 2 having a generally circular shape. The outer frame 2 is dimensioned to fit into the known container base described above to which a lid may be screw fitted. The holder may thus be securely held within the container and shielded from its environment. Integral with the outer frame 2 is an inner frame portion 3. Frame portion 3 comprises grips 4, 5, constituting the second gripping means, and grip 6 and strip 8 constituting the first gripping means, between which a substrate (not shown) may be held, and a support 7. Grip 6 is connected to frame 3 by connecting strip 8 and a thin strip 9. Due to the thinness of strip 9, it is relatively less rigid than support 7, thus by squeezing strip 9 and support 7 together, grip 6 will be displaced towards support 7, away from grips 4 and 5. The maximum possible displacement of the frame at grip 6 is limited by the support 7 to prevent inadvertent over-straining of the support and to provide a firm hold during manual squeezing. When it is required to insert a substrate into the holder, the grip 6 and support 7 are squeezed together until the distance between grip 6 and grips 4 and 5 is sufficient for a substrate to be io placed between the grips. The squeezing of grip 6 and support 7 is then discontinued, and grip 6 returns to its original position, and in doing so causes the substrate to be securely held in place. Support 7 serves to limit the maximum displacement of grip 6.

Referring now to Figure 2 each of the grips 4, 5, 6 comprises a ledge 10 and a sloping portion 11. Once a substrate has been placed between the grips, the sloping portion 11 of each grip 4, 5 and 6, guides the substrate towards the ledge 10, where it remains, the under surface of the substrate being in contact with the ledge 10. The ledges 10 lie in a plane which is spaced apart from the connecting strip 8 in order that the substrate does not come into contact with the strip 8. The substrate is thus held firmly in place, and is only in contact with the holder where its under surface touches the ledges 10.

The strip 8 has a sloping portion 12 which allows one side of a pair of tweezers to be slid under the substrate when it is required to remove the substrate. Once the tweezers are in place, grip 6 and support 7 may be squeezed together. This releases the substrate from the grips and allows the substrate to be removed by the tweezers. The frame 2 has a flat portion 15 which is shaped to be held by tweezers. This enables the holder to be easily transferred from one location to another without the object being touched.

Protrusions 13 formed in the frame portion 3 ensure that, should the substrate slip to one side of the frame 3, the frame will come into contact only with predetermined safe areas of the substrate. This reduces the possible damage to for example surface waveguides which end at the sides of the substrate.

The frame 1 is made from a single piece of polypropylene which is resistant to hot water and other solvents for cleaning. However, other suitable materials may be used if it is desired to use the holder for specific chemical treatments. Use of polypropylene allows the holder to be made of a unitary construction by simple manufacture techniques, for example, injection moulding. Polypropylene also has an appropriate heat resistance to allow substrate washing to be carried out without having to remove the object from the holder.

**Claims**

1. A holder for holding an object comprising a frame having first and second gripping means cooperable to hold the object, the first gripping means being resiliently flexible so as to be displaceable away from the second gripping means by squeezing it and a portion of the frame together thereby permitting the object to be placed between the first and second gripping means to be held by them on releasing the first gripping means.

2. A holder according to claim 1 wherein the second gripping means comprises first and second spaced apart grooved portions of the frame, and the first gripping means comprises a third grooved portion having a connecting portion connected to the frame by a resilient support, a portion of the second gripping means extending between the two spaced-apart, grooved portions.

3. A holder according to claim 2 wherein the resilient support is on the same side of the first and second grooved portions as the third grooved portion.

4. A holder according to claim 2 wherein the resilient support is on the opposite side of the first and second grooved portion from third grooved portions.

5. A holder according to any one of claims 2, 3 and 4 wherein the resilient support is a strip connected to the frame.

6. A holder according to any one of claims 2, 3, and 5 wherein the first, second and third grooved portions each have a ledge portion and a planar sloped portion at an acute angle to the ledge portion, the ledge portions being substantially co-planar and located to support the object.

7. A holder according to claim 6 wherein the plane of the ledge portions between the ledge is spaced from the connecting portion.

8. A holder according to claim 6 or claim 7 wherein the connecting portion comprises a sloping portion between the first and second gripping means.

9. A holder according to any one of the preceding claims wherein the frame portion is positioned such that it limits the maximum displacement of the second gripping means.

10. A holder according to any of the preceding claims further comprising an outer frame.

11. A holder according to any of the preceding claims wherein the inner frame comprises a flat portion for holding by tweezers.

12. A holder according to any of the preceding claims wherein parts of the frame adjacent the object to be held are profiled such that only part of the object contacts the frame.

13. A holder according to any of the preceding claims which is made of polypropylene.

14. A holder according to any of the preceding claims having a unitary construction.

15. A holder substantially as herein described with reference to the accompanying drawings.

# Fig.1.

# Fig. 2.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | US-A-3652974 (A. TEMS)<br>* column 5, lines 46 - 73; figures 15-17 * | 1, 5, 14 | H01L21/00<br>G02B6/30 |
| A | US-A-4760917 (J.I. VITEK)<br>* column 5, lines 26 - 45; figures 1-5 * | 1, 5, 14 | |
| A | EP-A-0087897 (BOURNS)<br>* abstract; figures 1, 2 * | 1, 14 | |
| A | US-A-3552548 (V.C. WALLESTAD ET AL.)<br>* abstract; figures 1-5 * | 1 | |

TECHNICAL FIELDS SEARCHED (Int. Cl.5 )

H01L
H05K
B65D
G02B
G02F

The present search report has been drawn up for all claims

| Place of search | Date of completion of the search | Examiner |
|---|---|---|
| THE HAGUE | 25 OCTOBER 1989 | LOMMEL A. |